# EUROPÄISCHE PATENTSCHRIFT

(11) **EP 1 459 611 B1**
(45) Veröffentlichungstag und Bekanntmachung des Hinweises auf die Patenterteilung: **22.06.2011**
(21) Anmeldenummer: 02798283.4
(22) Anmeldetag: 19.12.2002
(51) Int. Cl.: H05K 5/00

(54) **GEHÄUSEANORDNUNG FÜR EIN ELEKTRISCHES GERÄT**
HOUSING SYSTEM FOR AN ELECTRIC DEVICE
ENSEMBLE BOITIER POUR UN APPAREIL ELECTRIQUE

(30) Priorität: 20.12.2001 DE 10162600
(43) Veröffentlichungstag der Anmeldung: 22.09.2004
(73) Patentinhaber: ROBERT BOSCH GMBH, 70442 Stuttgart (DE)
(72) Erfinder: SCHIEFER, Peter, 74199 Unterheinriet (DE)
(86) Internationale Anmeldenummer: PCT/DE2002/004664
(87) Internationale Veröffentlichungsnummer: WO 2003/055289

(56) Entgegenhaltungen:
- EP-A- 1 006 766
- CH-A- 629 600
- DE-A- 4 117 179
- DE-A- 19 506 664
- US-A- 5 699 233
- US-A- 5 872 332
- US-A1- 2001 027 038
- US-A1- 2002 154 486

## Beschreibung

### Stand der Technik

Die Erfindung betrifft elektrisches Gerät mit einer Gehäuseanordnung, insbesondere für ein Steuer- oder Regelgerät mit einer auf einer Leiterplatte angeordneten elektronischen Schaltung, nach dem Oberbegriff des Hauptanspruchs.

Bei der Herstellung solcher Gehäuse für ein elektrisches Gerät, insbesondere zur Steuerung elektromechanischer Anordnungen beispielsweise im Kraftfahrzeug, muss beachtet werden, dass sowohl eine dichte und möglichst rüttelfreie Verbindung der Gehäuseteile, eine gute elektromagnetische Abschirmung (EMV) für die Steuergeräteelektronik sowie eine gute Wärmeabfuhr bei möglichst geringem Herstellungsaufwand erreichbar ist.

Es ist bereits aus der DE-OS 39 37 190 ein elektrisches Gerät bekannt, bei dem die Steuergeräteelektronik für Komponenten eines Verbrennungsmotor in einem Gehäuse angeordnet ist, das im Bereich der Motoraggregate angebracht ist. Das zweiteilige Gehäuse aus Metall, beispielsweise aus Aluminium-Druckguss, lässt sich elektromagnetisch abgeschirmt verschließen, wobei in das Gehäuse eine Anschlussvorrichtung für Verbindungsleitungen, eine sogenannte Messerleiste, integriert ist über die die Spannungsversorgung und die Übertragung von Mess- und Steuersignalen möglich ist. Diese Aluminiumgehäuse sind in der Regel sehr kostenaufwendig und die Wärmeabfuhr erfolgt über den Gehäusedeckel, wodurch eventuell ein relativ langer Weg zur Wärmesenke auftreten kann.

Aus der DE 42 43 180 A1 ist ein mehrteiliges Gehäuse für Steuergeräte bekannt, bei dem zur Erzielung einer guten Störstrahldichte und guter Wärmeableitung eine die Leistungsbauelemente und Steuerbauelemente tragende Leiterplatte mit einer umlaufenden Kaschierung aus elektrisch leitendem Material versehen ist. Die Leiterplatte wird hier im Bereich dieser Kaschierungen mit einer elektrisch leitenden Verbindung zwischen den Gehäusehälften eingespannt. Störstrahlintensive oder -empfindliche - Steuerelemente sind dabei von aus der Wand der Gehäuseteile vorstehenden Stutzen eingeschlossen.
Aus der DE 41 17 179 62 ist ein Gerät gemäß dem Oberbegriff des Anspruchs 1 bekannt.

### Vorteile der Erfindung

Das eingangs beschriebene Gerät mit einer Gehäuseanordnung mit mindestens zwei Gehäuseteilen und einer im Gehäuse anordbaren elektronischen Schaltung auf einer Leiterplatte, die eine mit der Gehäusemasse mindestens eines metallischen Gehäuseteils verbundene leitende Schicht aufweist, ist erfindungsgemäß mit den kennzeichnenden Merkmalen des Anspruchs 1 in vorteilhafter Weise weitergebildet. Bevorzugt ist hierbei das jeweils andere Gehäuseteil ein Kunststoffteil, in das die mindestens eine Anschlussvorrichtung für die Spannungsversorgung des Geräts und/oder die Signalübertragung zu der elektronischen Schaltung integriert ist. Hierbei kann die Anschlussvorrichtung auf einfache Weise beispielsweise mittig im Kunststoffgehäuseteil angeordnet werden, so dass sich kurze, störstrahlungsmäßig somit günstige Leitungswege zu den oft aus thermischen Gründen an unterschiedlichen Randbereichen angeordneten Leistungsbauelementen ergeben.

In vorteilhafter Weise kann gemäß der Erfindung die Leiterplatte beidseitig bestückt sein, wobei störstrahlungsempfindliche Bauelemente auf der Seite angeordnet sind, die vom metallischen Gehäuseteil und der leitenden Schicht weitgehend umschlossen ist. Andere Bauelemente und Kontaktierungen einer oder mehrerer Anschlussvorrichtung sind dann auf der anderen Seite der Leiterplatte angeordnet sind.

Weiterhin sind in vorteilhafter Weise auf der Seite der Leiterplatte, die der Anschlussvorrichtung gegenüberliegt bzw. auch im Bereich der Befestigung der Leiterplatte an dem metallischen Gehäuseteil, Leistungsbauelemente angeordnet. Die Leiterplatte kann dabei in herkömmlicher Weise aus einem Substrat oder Laminat bzw. auch als Folie aufgebaut sein.

Mit der Erfindung kann auf einfache weise erreicht werden, dass das Gehäuse eines Steuergeräts kosten- und fertigungsoptimiert werden kann. Es kann eine Reduzierung der Einzelelemente und Fertigungsschritte erreicht werden, wobei trotz des Einsatzes eines Kunststoffgehäuseteils den kritischen EMV-Bedingungen Rechnung getragen werden kann, da alle EMV-kritischen Bauelemente auf der, dem metallischen Teil, z.B. dem Unterteil des Gehäuses, gegenüberliegend Seite der Leiterplatte angebracht werden können.

Zusammen mit der abschirmenden Fläche, z.B. eine Kupferlage, in der Leiterplatte, welche mit dem metallischen Unterteil kontaktiert ist, entsteht näherungsweise ein Faradayscher Käfig, durch den unerwünschte Einstrahlungen als auch Abstrahlungen wirksam unterdrückt werden können. Wenn die Leistungsbauelemente und die Anschlussvorrichtungen zusammen mit den Kontaktierungen auf der anderen Seite der Leiterplatte angeordnet sind, kann der Abschirmungseffekt der EMV-kritischen Bauelemente noch verstärkt werden und nebenher noch die Leitungsführung auf der Leiterplatte noch vereinfacht werden.

Die Wärmeäbführung von den Leistungsbauelementen kann im Bereich der Montage der Leiterplatte zum metallischen Gehäuseteil erfolgen, so dass ein kurzer Kontakt zu einer Wärmesenke möglich ist. Weiterhin ist auch eine Anbringung von zusätzlichen Kühlrippen am metallischen Gehäuseteil, z.B. unter Ausnutzung von Luftströmungen, wie eine Kühlung im Bereich des Luftfilters eines Kraftfahrzeuges, möglich.

Vorteilhaft ist das erfindungsgemäße Gehäuse weitergebildet, wenn das Gehäuseteil mit der Anschlussvorrichtung Niederhalter und/oder Federn zur Stabilisierung der Lage der Leiterplatte oder von bestimmten Bauelementen während der Montage, z.B. für den Lötprozess, oder nach der Montage zur Erhöhung der Schüttelsicherheit aufweist. Auch eine Ausbildung von Rippen im Kunststoffgehäuseteil dient der weitern Stabilisierung und Erhöhung der Rüttelfestigkeit der Anordnung.

Im Gehäuseteil aus Kunststoff kann auf einfache Weise auch ein Druckausgleichselement montiert sein, welches insbesondere durch Umspritzen mit Kunststoff währen der Herstellung des Gehäuseteils oder durch nachträgliches Einschnappen in eine Ausnehmung über Schnapphaken eingefügt werden kann.

Es kann zur einfachen Herstellung dichter Gehäuse auf einfache Weise direkt zwischen den aneinanderliegenden Gehäuseteilen eine an der Kontur der Gehäuseteile umlaufende Dichtung angebracht werden. Die Dichtkontur liegt hier nur ein einer Ebene zwischen den Gehäuseteilen und ist nicht mit der Leiterplatte verbunden. Mit dem Kunststoffgehäuseteil als Deckel ist eine Isolation der Innenluft gegenüber eventuell hohen Umgebungstemperaturen gewährleistet.

Die Anschlussvorrichtung kann in vorteilhafter Weise mit geraden Kontaktpins versehen sein, die direkt auf die Leiterplatte geführt sind. Dadurch kann eine gegebenenfalls notwendige Führungsleiste entfallen und es kann eine kostengünstig zu realisierende Kontaktart, wie z.B. Einpressen oder partielles Löten, gewählt werden. Hier können eventuell noch Schultern im Kunststoffgehäuseteil zur Abstützung der Pins beim Einpressen der Pins kostengünstig vorgesehen werden.

Das Gehäuseteil mit der Anschlussvorrichtung aus Kunststoff kann darüber hinaus auch noch auf einfache Weise zur Erhöhung der EMV-Sicherheit des ganzen Geräts mit einer inneren Metallisierung versehen sein. Es ist aber auch diesbezüglich möglich, dass das Gehäuseteil aus Kunststoff unter Einschluss der Anschlussvorrichtung mit einem zusätzlichen metallischen oder metallisierten Gehäuseteil umschlossen ist.

### Zeichnung

Ein Ausführungsbeispiel eines erfindungsgemäßen Gehäuses für ein elektrisches Steuergerät für ein Fahrzeug wird anhand der Zeichnung erläutert. Es zeigen:
Figur 1 einen senkrechten Schnitt durch das Gehäuse eines elektrischen Steuergeräts mit einer beidseitig bestückten Leiterplatte und
Figur 2 eine Draufsicht auf das Gehäuse nach der Figur 1.

### Beschreibung des Ausführungsbeispiels

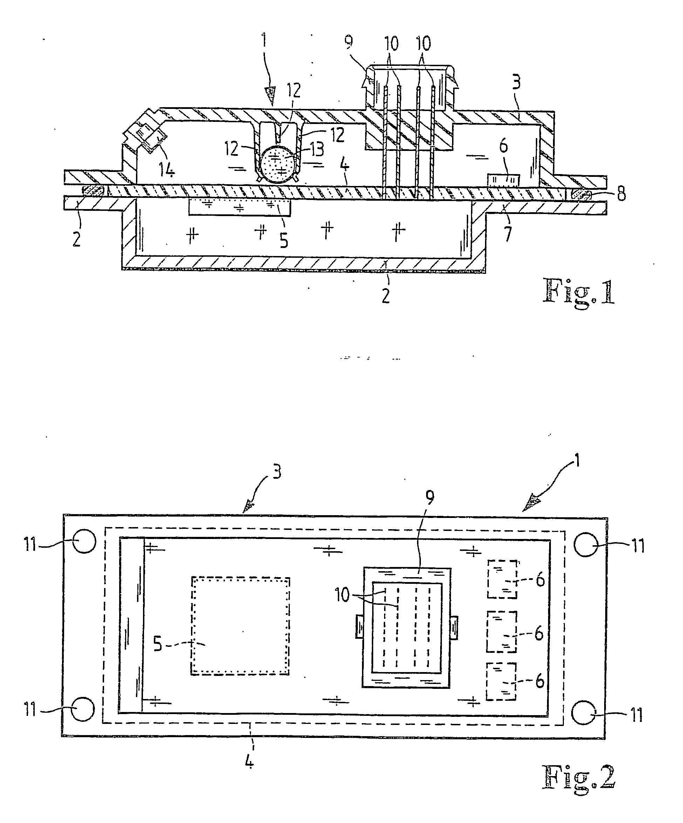

Figur 1 zeigt eine Schnittansicht durch ein Steuergerät 1 mit einem unteren Gehäuseteil 2 aus Metall, z.B. Aluminium-Druckguss, und einem oberen Gehäuseteil 3 aus Kunststoff. Zwischen den beiden Gehäuseteilen 2 und 3 liegt eine Leiterplatte 4, die in einer hier nicht sichtbaren Weise mit einer leitenden Schicht versehen ist, welche wiederum mit dem metallischen Gehäuseteil 2 kontaktiert ist.

Unterhalb der Leiterplatte 4 sind Bauelemente 5 der elektronischen Schaltung des Steuergeräts 1 angebracht, die somit EMV-geschützt zwischen dem metallischen Unterteil 2 des Gehäuses und der leitenden Schicht der Leiterplatte 4 liegen.

Oberhalb der Leiterplatte 4 sind Leistungsbauelemente 6 angebracht, die in einem Bereich der Leiterplatte 4 angeordnet sind, wobei dieser Bereich an dem unteren Gehäuseteil 2 direkt anliegt, so dass ein Teil 7 des Gehäuseunterteils 2 als Kühlfläche für die Leistungsbauelemente 6 dienen kann. Weiterhin ist auch eine hier nicht gezeigte Anordnung von Kühlrippen am Unterteil 2 zur Ausnutzung von Luftströmungen möglich. Der Gehäusedeckel 3 kann auch noch nicht gezeigte Niederhalter und/oder Federn 12 zur Stabilisierung der Lage der Leiterplatte 4 oder von weiteren Bauelementen 13, wie z.B. Elektrolytkondensatoren während der Montage, z.B. für den Lötprozess, oder nach der Montage zur Erhöhung der Rüttelsicherheit aufweisen.

Zwischen den Gehäuseteilen 2 und 3 ist noch eine umlaufende Dichtung 8 zur Abdichtung des gesamten Geräts 1 angebracht. Die Dichtkontur liegt hier in einer Ebene zwischen den Gehäuseteilen 2 und 3 und ist nicht mit der Leiterplatte 4 verbunden.

Im oberen Gehäuseteil 3, dem Deckel des Geräts 1, ist als mindestens eine Anschlussvorrichtung für die Spannungsversorgung des Geräts und/oder die Signalübertragung zu der elektronischen Schaltung auf der Leiterplatte 4 eine Messerleiste 9 integriert. Die Messerleiste 9 ist hier mit geraden Kontaktpins 10 versehen, die direkt auf die Leiterplatte 4 geführt sind, wobei hier eine günstige Kontaktart, wie z.B. Einpressen oder partielles Löten, für die Kontaktpins 10 vorgesehen werden kann. Weiterhin ist im Gehäuseteil 3 ein Druckausgleichselement 14 angeordnet, das z.B. durch Umspritzen während der Herstellung des Gehäuseteils 3 oder durch nachträgliches Einschnappen in eine Ausnehmung über Schnapphaken eingefügt werden kann.

Aus Figur 2 ist eine Draufsicht auf das Steuergerät 1 nach der Figur 1 zu entnehmen, bei der der Gehäusedeckel 3 mit Befestigungslöchern 11 für das gesamte Gehäuse und die Anschlussvorrichtung mit der Messerleiste 9 und den Kontaktpins 10 sichtbar ist. Die nicht sichtbare Leiterplatte 4, die elektronischen Bauelemente 5 und die Leistungsbauelemente 6 sind gestrichelt gezeichnet.

## Patentansprüche

1. Elektrisches Gerät (1), mit einer Gehäuseanordnung mit
- mindestens einem ersten und zweiten Gehäuseteil (2,3) und einer im Ge- ' rät (1) anordbaren elektronischen Schaltung auf einer Leiterplatte (4), die eine mit der Gehäusemasse mindestens eines metallischen Gehäuseteils (2) verbundene leitende Schicht aufweist,
- wobei das zweite Gehäuseteil (3) ein Kunststoffteil ist **dadurch gekennzeichnet, dass** die Leiterplatte (4) beidseitig bestückt ist, wobei störstrahlungsempfindliche Bauelemente (5) auf der Seite angeordnet sind, die vom metallischen Gehäuseteil (2) und der leitenden Schicht weitgehend umschlossen sind und dass andere Bauelemente (6) und Kontaktierungen einer Anschlussvorrichtung (9) auf der anderen Seite der Leiterplatte (4) angeordnet sind.

2. Gerät nach Anspruch 1, **dadurch gekennzeichnet, dass**
- das auf der Seite der Leiterplatte (4), die der Anschlussvorrichtung (9) gegenüberliegt, im Bereich (7) der Befestigung der Leiterplatte (4) an dem metallischen Gehäuseteil (2) Leistungsbauelemente (6) angeordnet sind.

3. Gerät nach einem der vorhergehenden Ansprüche, **dadurch gekennzeichnet, dass**
- das Gehäuseteil (3) mit der Anschlussvorrichtung (9) Niederhalter und/oder Federn (12) zur Stabilisierung der Lage der Leiterplatte (4) oder der Bauelemente (13) nach der Montage aufweist.

4. Gerät nach einem der vorhergehenden Ansprüche, **dadurch gekennzeichnet, dass**
- direkt zwischen den aneinanderliegenden Gehäuseteilen (2,3) eine an der Kontur der Gehäuseteile (2,3) umlaufende Dichtung (8) vorhanden ist.

5. Gerät nach einem der vorhergehenden Ansprüche, **dadurch gekennzeichnet, dass**
- die Anschlussvorrichtung (9) mit Kontaktpins (10) versehen ist, die direkt auf die Leiterplatte (4) geführt sind.

6. Gerät nach Anspruch 5, **dadurch gekennzeichnet, dass**
- die Kontaktpins (11) mittels Einpresstechnik mit den Leiterbahnen der Leiterplatte (4) kontaktiert sind.

7. Gerät nach Anspruch 5, **dadurch gekennzeichnet, dass**
- die Kontaktpins (11) mittels Löttechnik mit den Leiterbahnen der Leiterplatte (4) kontaktiert sind.

8. Gerät nach einem der vorhergehenden Ansprüche, **dadurch gekennzeichnet, dass**
- das Gehäuseteil (3) mit der Anschlussvorrichtung (9) aus Kunststoff mit einer inneren Metallisierung versehen ist.

9. Gerät nach einem der vorhergehenden Ansprüche, **dadurch gekennzeichnet, dass**
- im Gehäuseteil (3) ein Druckausgleichselement (14) montiert ist, insbesondere durch Umspritzen mit Kunststoff währen der Herstellung des Gehäuseteils (3).

10. Gerät nach einem der vorhergehenden Ansprüche, **dadurch gekennzeichnet, dass**
- das Gehäuseteil (3) mit der Anschlussvorrichtung (9) aus Kunststoff ist und unter Einschluss der Anschlussvorrichtung (9) mit einem zusätzlichen metallischen oder metallisierten Gehäuseteil umschlossen ist.

## Claims

1. Electrical apparatus (1) comprising a housing arrangement comprising
- at least a first and second housing part (2, 3) and an electronic circuit that can be arranged in the apparatus (1) on a printed circuit board (4), which has a conductive layer connected to the housing mass of at least one metallic housing part (2),
- wherein the second housing part (3) is a plastic part, **characterized in that** the printed circuit board is populated on both sides, wherein components (5) sensitive to interference radiation are arranged on the side largely enclosed by the metallic housing part (2) and the conductive layer, and other components (6) and contact-connections of a connection device (9) are arranged on the other side of the printed circuit board (4).

2. Apparatus according to Claim 1, **characterized in that**
- power components (6) are arranged on the side of the printed circuit board (4) which lies opposite the connection device (9), in the region (7) where the printed circuit board (4) is fixed to the metallic housing part (2).

3. Apparatus according to either of the preceding claims, **characterized in that**
- the housing part (3) with the connection device (9) has holding-down units and/or springs (12) for stabilizing the position of the printed circuit board (4) or the components (13) after mounting.

4. Apparatus according to any of the preceding claims, **characterized in that**
- a seal (8) extending circumferentially at the contour of the housing parts (2, 3) is present directly between the adjacent housing parts (2, 3).

5. Apparatus according to any of the preceding claims, **characterized in that**
- the connection device (9) is provided with contact pins (10) that are lead directly onto the printed circuit board (4).

6. Apparatus according to Claim 5, **characterized in that**
- the contact pins (11) are contact-connected to the conductor tracks of the printed circuit board (4) by means of press-fit technology.

7. Apparatus according to Claim 5, **characterized in that**
- the contact pins (11) are contact-connected to the conductor tracks of the printed circuit board (4) by means of soldering technology.

8. Apparatus according to any of the preceding claims, **characterized in that**
- the housing part (3) with the connection device (9) composed of plastic is provided with an inner metallization.

9. Apparatus according to any of the preceding claims, **characterized in that**
- a pressure compensating element (14) is mounted in the housing part (3), in particular by encapsulation with plastic by injection moulding during the production of the housing part (3).

10. Apparatus according to any of the preceding claims, **characterized in that**
- the housing part (3) with the connection device (9) is composed of plastic and is enclosed with the inclusion of the connection device (9) with an additional metallic or metallized housing part.

## Revendications

1. Appareil électrique (1) présentant un ensemble de boîtier et comprenant
- au moins une première et une deuxième partie de boîtier (2, 3) et un circuit électronique qui peut être disposé dans l'appareil (1) sur une carte de circuit (4) dont une couche conductrice est reliée à la masse d'au moins une partie métallique (2) du boîtier,
- la deuxième partie (3) du boîtier étant une partie en matière synthétique,
**caractérisé en ce que**
la carte de circuit (4) est dotée de composants sur ses deux faces, des composants (5) sensibles aux rayonnements parasites étant disposés sur la face largement englobée par la partie métallique (2) du boîtier et par la couche conductrice et
**en ce que** d'autres composants (6) et contacts d'un dispositif de raccordement (9) sont disposés sur l'autre face de la carte de circuit (4).

2. Appareil selon la revendication 1, **caractérisé en ce que** des composants de puissance (6) sont disposés sur la face de la carte de circuit (4) située face au dispositif de raccordement (9), au niveau (7) de la fixation de la carte de circuit (4) sur la partie métallique (2) du boîtier.

3. Appareil selon l'une des revendications précédentes, **caractérisé en ce qu'**après le montage, la partie (3) du boîtier et le dispositif de raccordement (9) présentent des dispositifs de retenue et/ou des ressorts (12) qui stabilisent la position de la carte de circuit (4) ou des composants (13).

4. Appareil selon l'une des revendications précédentes, **caractérisé en ce qu'**un joint d'étanchéité périphérique (8) qui suit le contour des parties (2, 3) du boîtier est prévu directement entre les parties adjacentes (2, 3) du boîtier.

5. Appareil selon l'une des revendications précédentes, **caractérisé en ce que** le dispositif de raccordement (9) est doté de goujons de contact (10) qui sont amenés directement sur la carte de circuit (4).

6. Appareil selon la revendication 5, **caractérisé en ce que** les goujons de contact (11) sont mis en contact avec les pistes conductrices de la carte de circuit (4) au moyen d'une technique de pressage.

7. Appareil selon la revendication 5, **caractérisé en ce que** les goujons de contact (11) sont mis en contact avec les pistes conductrices de la carte de circuit (4) au moyen d'une technique de brasage.

8. Appareil selon l'une des revendications précédentes, **caractérisé en ce que** la partie (3) du boîtier et le dispositif de raccordement (9) en matière synthétique sont dotés d'une métallisation interne.

9. Appareil selon l'une des revendications précédentes, **caractérisé en ce qu'**un élément (14) d'équilibrage de pression est monté dans la partie (3) du boîtier, en particulier en étant englobé par de la matière synthétique pendant la fabrication de la partie (3) du boîtier.

10. Appareil selon l'une des revendications précédentes, **caractérisé en ce que** la partie (3) du boîtier et le dispositif de raccordement (9) sont réalisés en matière synthétique, le dispositif de raccordement (9) étant englobé dans une partie supplémentaire métallique ou métallisée de boîtier.
